(19) Europäisches Patentamt
European Patent Office
Office européen des brevets

(11) **EP 4 462 091 A1**

(12) **EUROPEAN PATENT APPLICATION**
published in accordance with Art. 153(4) EPC

(43) Date of publication:
**13.11.2024 Bulletin 2024/46**

(21) Application number: **22931028.9**

(22) Date of filing: **02.12.2022**

(51) International Patent Classification (IPC):
*G01J 1/02* (2006.01)     *G01J 1/44* (2006.01)
*G01J 11/00* (2006.01)     *G01T 1/16* (2006.01)
*G01T 1/26* (2006.01)     *H10N 60/00* (2023.01)

(52) Cooperative Patent Classification (CPC):
G01J 1/02; G01J 1/44; G01J 11/00; G01T 1/16;
G01T 1/26; H10N 60/00

(86) International application number:
**PCT/JP2022/044611**

(87) International publication number:
**WO 2023/171057 (14.09.2023 Gazette 2023/37)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**KH MA MD TN**

(30) Priority: **09.03.2022 JP 2022036155**

(71) Applicant: **Hamamatsu Photonics K.K.
Hamamatsu-shi, Shizuoka 435-8558 (JP)**
(72) Inventors:
• **SUGIURA Ginji**
  **Hamamatsu-shi, Shizuoka 435-8558 (JP)**
• **ASAI Masato**
  **Hamamatsu-shi, Shizuoka 435-8558 (JP)**

(74) Representative: **Grünecker Patent- und
Rechtsanwälte
PartG mbB
Leopoldstraße 4
80802 München (DE)**

(54) **ENERGY BEAM DETECTING SYSTEM**

(57)     An energy ray detection system includes a vacuum vessel 2 having a first cold head 23, and n circuit units 8 each having a first signal line 81, a detection element 82 connected to one terminal 81a of the first signal line 81 and configured to detect an energy ray in a low temperature state, and a signal processing circuit 84 including an amplifier 85 connected to the other terminal 81b of the first signal line 81, a current source 86, and a shunt resistor 87. A resistance value R of the first signal line 81 is larger than a value based on the number n of first signal lines 81, a temperature $T_1$ of the first signal line 81 on the one terminal 81a side, a temperature $T_2$ of the first signal line 81 on the other terminal 81b side, and a cooling capacity $W_c$ of a cooler, and is smaller than a value based on a noise allowable voltage $V_N$, a resistance value $R_{sh}$ of a shunt resistor, resistance values $R_s$ and $R_n$ in a case where the detection element 82 is OFF and in a case where the detection element is ON, and a current $I_b$ in a case where the detection element 82 is OFF.

*Fig.2*

## Description

### Technical Field

An aspect of an embodiment relates to an energy ray detection system.

### Background Art

In related art, a detection system for detecting an energy ray in a low temperature state is known. This system includes a detection element that operates in a low temperature state, a signal processing circuit that operates the detection element, and a signal line that connects the detection element and the signal processing circuit, and can detect the energy ray such as a photon. In the detection system of the related art, 1 to 20 detection elements are provided, and 1 to 20 signal lines connect the detection elements and the signal processing circuit. For example, Non Patent Literature 1 describes evaluation results of an operation of a detection system including a superconducting single photon detector (SSPD) and a signal processing circuit electrically connected to the detector.

### Citation List

### Non Patent Literature

Non Patent Literature 1: A. J. Kerman, E. A. Dauler, W. E. Keicher, J. K.W. Yang, K. K.Berggren, G. Goltsman, and B. Voronov, "Kinetic-inductance-limited reset time of superconducting nanowire photon counters" Appl. Phys. Lett. 88, 111116 (2006).

## Summary of Invention

### Technical Problem

In the detection system described above, there is a demand for increasing the number of detection elements and the number of signal lines in order to detect a plurality of signals. In this case, as the number of signal lines increases, since a total amount of heat flowing into the detection elements from an outside via the signal lines increases, there is a case where a low temperature state sufficient for the detection element to operate cannot be secured. On the other hand, although it is conceivable to increase a thermal resistance of each signal line in order to reduce the amount of flowing heat described above, when the thermal resistance of the signal line is increased, since an electrical resistance also increases, there is a tendency that a signal propagating through the signal line from the detection element is attenuated and the signal is buried in noise.

Therefore, an aspect of an embodiment has been made in view of such a problem, and an object thereof is to provide an energy ray detection system that can normally operate detection elements while improving signal quality when the number of detection elements is increased.

### Solution to Problem

An energy ray detection system according to an aspect of an embodiment includes a vacuum vessel having a cooler, and n (n is an integer of 2 or more) circuit units that each have a signal line of which at least a part is housed in the vacuum vessel, a detection element which is housed in the vacuum vessel, is connected between one terminal of the signal line and a predetermined potential, and is configured to detect an energy ray in a low temperature state, and a signal processing circuit which is directly or indirectly connected to an other terminal of the signal line, and is disposed outside the vacuum vessel. The signal processing circuit includes an amplifier connected to the other terminal and a current source and a circuit element connected in parallel with each other between the other terminal and the predetermined potential. A resistance value R of the signal line is larger than a value calculated based on the number n of signal lines, a temperature $T_1$ of the signal line on the one terminal side, a temperature $T_2$ of the signal line on the other terminal side, and a cooling capacity Wc of the cooler, and is smaller than a value calculated based on a noise allowable voltage $V_N$ in the amplifier, an impedance $Z_{sh}$ of the circuit element, a resistance value $R_s$ of the detection element in a case where the detection element does not detect the energy ray, a resistance value $R_n$ in a case where the detection element detects the energy ray, and a current $I_b$ flowing through the detection element in a case where the detection element does not detect the energy ray.

In this energy ray detection system, when the energy ray is incident on the detection element housed in the vacuum vessel, a signal obtained by detecting the energy ray is input from the detection element to the amplifier of the signal processing circuit outside the vacuum vessel via the signal line. Here, according to the above aspect, the resistance value R of the signal line is larger than a value calculated based on the number n of signal lines, the temperature $T_1$ of the signal line on one terminal side, the temperature $T_2$ of the signal line on the other terminal side, and the cooling capacity Wc of the cooler. According to such a configuration, for example, the resistance value R can be set such that the total amount of heat flowing into the n detection elements is smaller than a value corresponding to the cooling capacity of the cooler, and it is possible to prevent the low temperature state of each detection element from being broken. In addition, according to the above aspect, the resistance value R of the signal line is smaller than a value calculated based on the noise allowable voltage $V_N$ in the amplifier, the impedance $Z_{sh}$ of the circuit element, the resistance value $R_s$ of the detection element in a case where the detection element does not detect the energy ray , the resistance value $R_n$ of the detection element in a case where the detection element detects the energy ray, and the current $I_b$ flowing through the detection element in a case where the detection element does not detect the energy ray. According to such a configuration, for example, the resistance value R can be set such that intensity of the signal from the detection element is larger than a value corresponding to the noise allowable voltage $V_N$, and the signal from the detection element can be normally detected. From the above, when the number of detection elements is increased, it is possible to normally operate the detection element while improving the signal quality.

**Advantageous Effects of Invention**

According to the aspect of the present disclosure, it is possible to provide the energy ray detection system that can normally operate the detection elements while improving signal quality when the number of detection elements is increased.

**Brief Description of Drawings**

FIG. 1 is a schematic configuration diagram of an energy ray detection system according to an embodiment.
FIG. 2 is a circuit diagram showing an equivalent circuit of a circuit unit of the energy detection system in FIG. 1.
FIG. 3 is a graph for explaining operational effects of the energy detection system in FIG. 1.
FIG. 4 is a graph for explaining the operational effects of the energy detection system in FIG. 1.
FIG. 5 is a graph for explaining the operational effects of the energy detection system in FIG. 1.
FIG. 6 is a graph for explaining the operational effects of the energy detection system in FIG. 1.
FIG. 7 is a circuit diagram illustrating an equivalent circuit of a circuit unit of an energy ray detection system according to a modification.
FIG. 8 is a circuit diagram illustrating an equivalent circuit of a circuit unit of an energy ray detection system according to a modification.
FIG. 9 is a circuit diagram illustrating an equivalent circuit of a circuit unit of an energy ray detection system according to a modification.
FIG. 10 is a schematic configuration diagram of an energy ray detection system according to a modification.
FIG. 11 is a circuit diagram illustrating an equivalent circuit of a circuit unit of an energy ray detection system according to a modification.

**Description of Embodiments**

Hereinafter, an embodiment of the present disclosure will be described in detail with reference to the drawings. Note that, in the description, the same reference signs will be used for the same elements or elements having the same functions, and redundant description will be omitted.

[Outline of energy ray detection system]

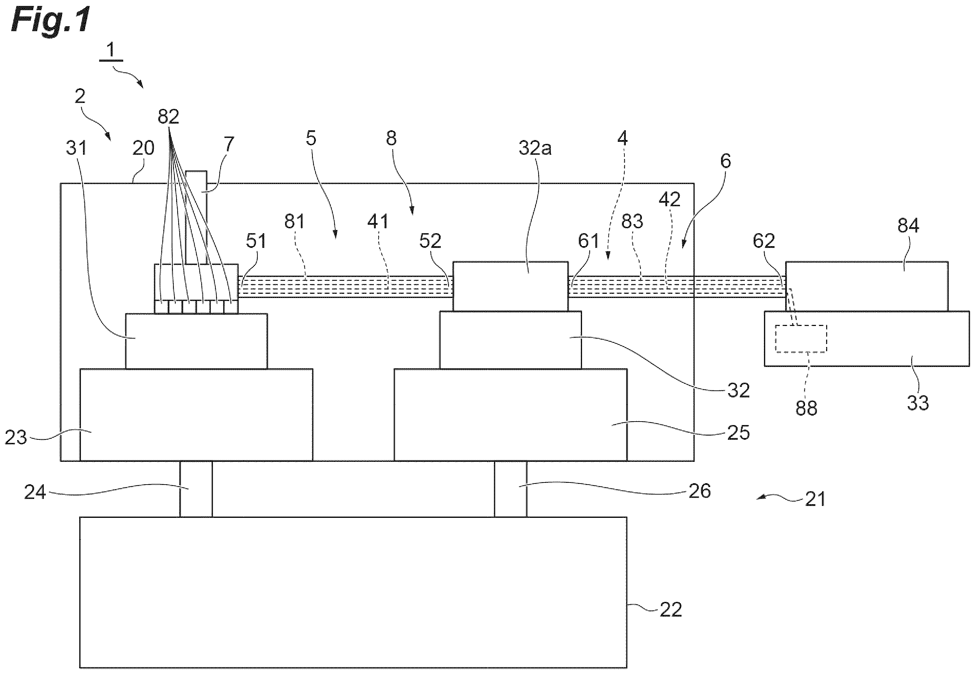

FIG. 1 is a schematic configuration diagram of an energy ray detection system according to an embodiment. An energy ray detection system 1 is a system for detecting an energy ray, and is a system used, for example, for detecting weak light. The energy ray detection system 1 includes a vacuum vessel 2, a main stage 31, a sub-stage 32, an atmospheric stage 33, a ground connection portion 4, a plurality of first connection portions 5, a plurality of second connection portions 6, and an optical fiber 7.

The vacuum vessel 2 includes a housing 20 and a refrigerator 21. An inside of the housing 20 is depressurized to be in a vacuum state. The refrigerator 21 includes a compressor unit 22, a first cold head (cooler) 23 housed in the housing 20, and a hose 24 connecting the compressor unit 22 and the first cold head 23. The compressor unit 22 compresses helium at a room temperature to generate liquid helium. The liquid helium generated by the compressor unit 22 is sent to the first cold head 23 via the hose 24. The first cold head 23 is in contact with the main stage 31 (to be described later), absorbs heat from the main stage 31, and releases the heat to the liquid helium.

The refrigerator 21 further includes a second cold head 25 housed in the housing 20 and a hose 26 connecting the compressor unit 22 and the second cold head 25. The liquid helium generated by the compressor unit 22 is sent to the second cold head 25 via the hose 26. The second cold head 25 is in contact with the sub-stage 32 (to be described later), absorbs heat from the sub-stage 32, and releases the heat to the liquid helium.

The main stage 31 is housed inside the housing 20. A plurality of detection elements 82 (to be described later) are provided in the main stage 31. The main stage 31 is cooled to, for example, 3 K by the first cold head 23. In addition, the sub-stage 32 is housed inside the housing 20. The sub-stage 32 is cooled to, for example, 50 K by the second cold head 25. A fixing jig 32a is provided in the sub-stage 32. The atmospheric stage 33 is disposed in an atmospheric pressure environment outside the housing 20. A plurality of signal processing circuits 84 and a plurality of ground potential connection portions 88 are provided in the atmospheric stage 33. A temperature of the atmospheric stage 33 is, for example, a room temperature. Note that, the ground potential connection portion 88 is connected to a predetermined potential, and the predetermined potential is a ground potential in the present embodiment.

The ground connection portion 4 includes a plurality of first ground lines 41 (ground lines) and a plurality of second ground lines 42. The plurality of first ground lines 41 are electrically connected to each other in the fixing jig 32a. The plurality of second ground lines 42 are electrically connected to each other in the fixing jig 32a. The ground connection portion 4 connects the detection element 82 and the ground potential connection portion 88. Specifically, the first ground line 41 connects the detection element 82 and the second ground line 42. The first ground line 41 and the second ground line 42 are connected to each other in the fixing jig 32a. The second ground line 42 connects the first ground line 41 and the ground potential connection portion 88. Note that, in the present embodiment, the ground connection portion 4 includes the first ground line 41 and the second ground line 42 for each circuit unit 8 (details will be described later.).

One end portion 51 of the first connection portion 5 is fixed to the main stage 31. The other end portion 52 of the first connection portion 5 is fixed to the fixing jig 32a of the sub-stage 32. In the present embodiment, the first connection portion 5 is provided for each circuit unit 8 (details will be described later.). The first connection portion 5 includes one first signal line 81 and one first ground line 41 therein. In the first connection portion 5, each first ground line 41 is integrated with the first signal line 81 while being electrically insulated from the first signal line 81. For example, the first connection portion 5 is a coaxial cable including one first signal line 81 that is an inner conductor surrounded by the first ground line 41 that is an outer conductor.

One end portion 61 of the second connection portion 6 is fixed to the fixing jig 32a of the sub-stage 32. The other end portion 62 of the second connection portion 6 is fixed to the atmospheric stage 33. In the present embodiment, the second connection portion 6 is provided for each circuit unit 8 (details will be described later). The second connection portion 6 includes one second signal line 83 and one second ground line 42 therein. In the second connection portion 6, each second ground line 42 is integrated with the second signal line 83 while being electrically insulated from the second signal line 83. For example, the second connection portion 6 is a coaxial cable including one second signal line 83 that is an inner conductor surrounded by the second ground line 42 that is an outer conductor.

The optical fiber 7 introduces an energy ray to be detected into the detection element 82 in the main stage 31 from an outside of the energy ray detection system 1. The introduced energy ray is incident on the plurality of detection elements 82.

The circuit unit 8 is a circuit for detecting the energy ray formed by the main stage 31, the sub-stage 32, the atmospheric stage 33, the ground connection portion 4, the first connection portion 5, and the second connection portion 6. In the energy ray detection system 1, n (n is an integer of 2 or more) circuit units 8 are provided. Each circuit unit 8 includes the first signal line 81, the detection element 82, the second signal line 83, and corresponding elements in the signal processing circuit 84. The detection element 82 is connected to the signal processing circuit 84 via the first signal line 81 and the second signal line 83. The first signal line 81 and the second signal line 83 are connected to each other in the fixing jig 32a. In addition, the number n of circuit units 8 is the number of detection elements 82 in the energy ray detection system 1, the number of first signal lines 81, and the number of second signal lines 83. Note that, n may be 30 or more, and more preferably 100 or more.

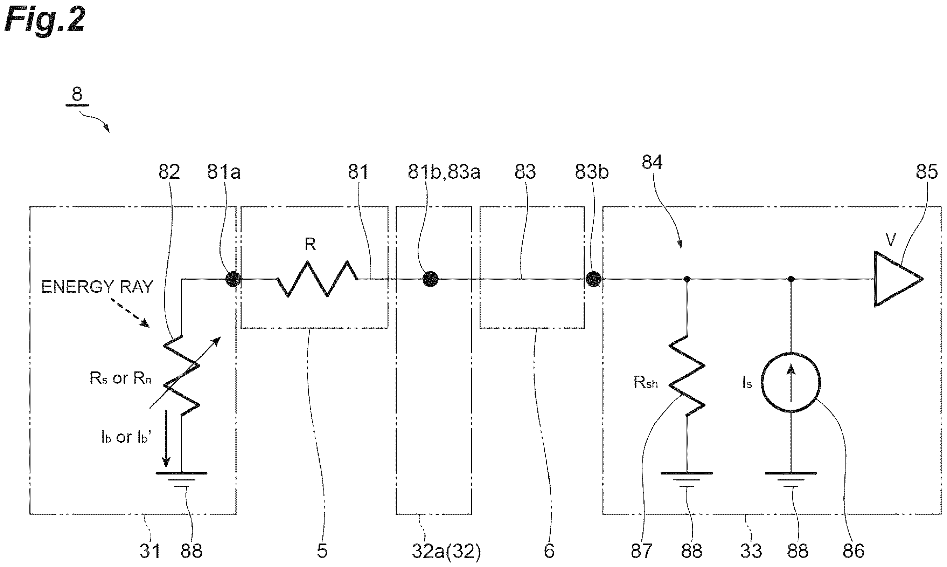

FIG. 2 is a diagram illustrating an equivalent circuit of the circuit unit of the energy ray detection system. The signal processing circuit 84 includes an amplifier 85, a current source 86, and a shunt resistor (circuit element) 87. The detection element 82 is connected between one terminal 81a of the first signal line 81 and the ground potential connection portion 88. One terminal 83a of the second signal line 83 is connected to the other terminal 81b of the first signal line 81. The amplifier 85 of the signal processing circuit 84 is connected to the other terminal 83b of the second signal line 83. The current source 86 and the shunt resistor 87 are connected in parallel with each other between the other terminal 83b and the ground potential connection portion 88. That is, the amplifier 85 is indirectly connected to the other terminal 81b of the first signal line 81 via the second signal line 83, and the current source 86 and the shunt resistor 87 are connected between the other terminal 81b of the first signal line and the ground potential connection portion 88 via the second signal line 83.

The detection element 82 is an element that detects an energy ray in a low temperature state. The detection element 82 is, for example, an element that detects an energy ray in a superconducting state. The detection element 82 is, for example, an element that detects photons. As an example, a detector having n detection elements 82 is a superconducting single photon detector (SSPD). In addition, in the present embodiment, in a case where the detection element 82 is the element that detects the energy ray in the superconducting state, a resistance value $R_s$ (to be described later) in a case where the detection element 82 does not detect the energy ray is 0.

An operation of each circuit unit 8 will be described. In the equivalent circuit of the circuit unit 8 in FIG. 2, in a case where the energy ray is detected in the detection element 82, the resistance value of the detection element 82 changes and a current flowing through the detection element 82 changes. At this time, since a current generated from the current source 86 is a constant value, a current flowing through the shunt resistor 87 increases. As a result, a voltage input to the amplifier 85 increases. As described above, the incident of the energy ray in the detection element 82 is detected as a change in the voltage input to the amplifier 85.

[Setting of Resistance Value R of First Signal Line 81]

In the energy ray detection system 1, as the number n of circuit units 8 increases, the number n of first signal lines 81 also increases. In this case, since a total amount of heat flowing into the plurality of detection elements 82 from the outside increases, it may not be possible to secure a sufficiently low temperature state for the detection elements 82 to operate. On the other hand, although it is conceivable to increase thermal resistance of each first signal line 81 in order to reduce the amount of flowing heat described above, when the thermal resistance of the first signal line 81 is increased, since the resistance value R of the first signal line 81 also increases, a signal propagating through the first signal line 81 from the detection element 82 is attenuated and the signal tends to be buried in noise. Accordingly, in the energy ray detection system 1, a range of the resistance value R of the first signal line 81 is set between a maximum value and a minimum value to be described later such that a normal operation can be performed while improving signal quality when the number of detection elements 82 is increased.

First, the maximum value of the range of the resistance value R of the first signal line 81 is determined by whether or not the signal from the detection element 82 can be detected. Specifically, first, in the circuit unit 8, the larger the resistance value R of the first signal line 81, the smaller a change in input voltage V to the amplifier 85 in a case where the detection element 82 detects the energy ray, and the signal from the detection element 82 is attenuated. Thus, when the resistance value R of the first signal line 81 is too large, the signal from the detection element 82 falls below a noise allowable voltage of the input voltage V, and the signal cannot be detected. In other words, the maximum value of the resistance value R of the first signal line 81 is a maximum value among resistance values R set such that intensity of the signal from the detection element 82 exceeds the noise allowable voltage of the input voltage V

The minimum value of the range of the resistance value R of the first signal line 81 is determined by cooling capacity of the first cold head 23 and an operating temperature of the detection element 82. Specifically, when the resistance value R of the first signal line 81 is reduced, since the thermal resistance of the first connection portion 5 including the first signal line 81 and the first ground line 41 is reduced, the amount of heat flowing into the detection element 82 via the first connection portion 5 is increased. When the resistance value R is too small, the total amount of heat flowing into the n detection elements 82 exceeds the cooling capacity of the first cold head 23. The temperature of the detection element 82 increases, and the detection element 82 may not operate. In other words, the minimum value of the resistance value R of the first signal line 81 is a minimum value among the resistance values R set such that the total amount of heat flowing into the n detection elements 82 falls below the cooling capacity of the first cold head 23.

[Calculation of Maximum Value of Range of Resistance Value R of First Signal Line 81]

Numerical examples of the maximum value of the range of the resistance value R of the first signal line 81 set in the energy ray detection system 1 will be described in detail. In the following description, in the equivalent circuit of the circuit unit 8 in FIG. 2, a resistance value of the first signal line 81 is R, the resistance value of the detection element 82 in a case where the energy ray is not detected in the detection element 82 (hereinafter, referred to as a "case where the detection element 82 is OFF") is $R_s$, and a current (bias current) flowing through the detection element 82 in a case where the detection element 82 is OFF is $I_b$. In addition, a resistance value of the detection element 82 in a case where the detection element 82 detects the energy ray (hereinafter, referred to as a "case where the detection element 82 is ON") is $R_n$, and a current (bias current) flowing through the detection element 82 in a case where the detection element 82 is ON is $I_b'$. In addition, a current (steady current) generated from the current source 86 is set as $I_s$, a resistance value $R_{sh}$ of the shunt resistor 87, and a voltage (hereinafter, referred to as an input voltage) input to the amplifier 85 is set as V. Note that, in a case where the signal processing circuit 84 includes elements and the like other than the amplifier 85, the current source 86, and the shunt resistor 87, the elements and the shunt resistor 87 are combined into one circuit element. In this case, instead of the resistance value $R_{sh}$ of the shunt resistor 87, an impedance $Z_{sh}$ of the circuit element is used for the following calculation.

First, the bias current $I_b$ in a case where the detection element 82 is OFF and the bias current $I_b$' in a case where the detection element is ON are expressed as the following Equation (2-1). Accordingly, a relationship between the bias current $I_b$ in a case where the detection element 82 is OFF and the bias current $I_b$' in a case where the detection element is ON is expressed as the following Equation (2-2).

[Math. 1]

$$I_s = \frac{R_s + R + R_{sh}}{R_{sh}} I_b = \frac{R_n + R + R_{sh}}{R_{sh}} I_b' \qquad \cdots (2-1)$$

$$\therefore I_b' = \frac{R_s + R + R_{sh}}{R_n + R + R_{sh}} I_b \qquad \cdots (2-2)$$

Subsequently, an input voltage $V_{OFF}$ in a case where the detection element 82 is OFF is expressed as the following Equation (3-1). In addition, an input voltage $V_{ON}$ in a case where the detection element 82 is ON is expressed as the following Equation (3-2) by using Equation (2-2). Accordingly, a difference $\Delta V$ in the input voltage between the case where the detection element 82 is OFF and the case where the detection element is ON is expressed as Equation (3-3) by using Equations (3-1) and (3-2).

[Math. 2]

$$V_{off} = (R_s + R)I_b \qquad \cdots (3-1)$$

$$V_{on} = (R_n + R)I_b' = \frac{R_s + R + R_{sh}}{R_n + R + R_{sh}} (R_n + R)I_b \qquad \cdots (3-2)$$

$$\Delta V = V_{on} - V_{off} = \frac{R_{sh}(R_n - R_s)}{R_n + R + R_{sh}} I_b \qquad \cdots (3-3)$$

From the above calculation result, the maximum value of the range of the resistance value R of the first signal line 81 is expressed as follows. Specifically, first, the case where the signal from the detection element 82 is detected is a case where the difference $\Delta V$ in the input voltage exceeds a noise allowable voltage $V_N$ in the amplifier 85 as in Equation (4-1). Accordingly, the maximum value of the range of the resistance value R of the first signal line 81 is given as the maximum value of the range represented by Equation (4-1) calculated by substituting Equation (3-3) into Equation (4-2) to be organized. That is, the resistance value R of the first signal line 81 is set to be smaller than a value calculated based on the noise allowable voltage $V_N$, the resistance value $R_{sh}$ of the shunt resistor 87, the resistance value $R_s$ in a case where the detection element 82 is OFF, the resistance value $R_n$ in a case where the detection element 82 is ON, and the bias current $I_b$ flowing through the detection element 82 in a case where the detection element 82 is OFF. Note that, the noise allowable voltage $V_N$ is generally obtained by multiplying an amplifier input conversion noise $\sigma_n$ by a preset constant m and expressed as the following Equation (4-3). A range of the constant m may be a practical range in the detection of the energy ray, and for example, m is 3.0 or more and 6.0 or less.

[Math. 3]

$$\Delta V > V_N \qquad \cdots (4-1)$$

$$R < \frac{(R_n - R_s)R_{sh}I_b}{V_N} - R_{sh} - R_n \qquad \cdots (4-2)$$

$$V_N = m\sigma_n \qquad \cdots (4-3)$$

[Calculation of Minimum Value of Range of Resistance Value R of First Signal Line 81]

Numerical examples of the minimum value of the range of the resistance value R of the first signal line 81 set in the energy ray detection system 1 will be described in detail. In the following description, a thermal resistance of the first connection portion 5 is $R_T$, a cooling capacity of the first cold head 23 is $W_c$, a temperature of one terminal 81a of the first signal line 81 is $T_1$, a temperature of the other terminal 81b of the first signal line 81 is $T_2$, and a temperature of the first connection portion 5 is T. Note that, $T_1$ is also a temperature of the main stage 31, and $T_2$ is also a temperature of the sub-stage 32.

The amount of heat flowing into the detection element 82 is the amount of heat flowing into the one end portion 51 from the other end portion 52 of the first connection portion 5. The amount of heat flowing into the detection element 82 is calculated as $(T_2 - T_1)/R_T$. The sum of the amounts of heat flowing into the plurality of detection elements 82 is a numerical value obtained by multiplying the flowing amounts by the number n of first connection portions 5, and is calculated as $(T_2 - T_1)n/R_T$.

Here, the thermal resistance $R_T$ of the first connection portion 5 needs to be set such that the total amount of heat flowing into the plurality of detection elements 82 does not exceed the cooling capacity $W_c$ of the first cold head 23. Accordingly, a condition to be satisfied by the thermal resistance $R_T$ of the first connection portion 5 is expressed by Equation (5-1). Here, the thermal resistance $R_T$ of the first connection portion 5 is expressed as Equation (5-2) as a function depending on the resistance value R of the first signal line 81 according to the Wiedemann-Franz rule. However, in the following Equation (5-2), a constant L is the Lorentz number, and is, for example, $2.44 \times 10^{-8}$ [$W\Omega/K^2$]. In addition, A represents a ratio of the combined thermal resistance of the first signal line 81 and the first ground line 41 to the thermal resistance of the first signal line 81.

[Math. 4]

$$\frac{T_2 - T_1}{R_T} < \frac{W_c}{n} \qquad \cdots (5-1)$$

$$R_T = \frac{1}{LTA} R \qquad \cdots (5-2)$$

Accordingly, the minimum value of the range of the resistance value R of the first signal line 81 is derived by substituting Equation (5-2) into Equation (5-1). Specifically, under the assumption that the first connection portion 5 has a uniform temperature gradient, the temperature T of the first connection portion 5 is approximated as $(T_2 + T_1)/2$, the approximated result is substituted into Equation (5-2), and Equation (5-2) is substituted into Equation (5-1) to be organized. As a result, the minimum value of the range of the resistance value R of the first signal line 81 is expressed as shown in the following Equation (6). That is, the resistance value R of the first signal line 81 is set to be larger than a value calculated based on the number n of first signal lines 81, the temperature $T_1$ of the first signal line 81 on the one terminal 81a side, the temperature $T_2$ of the first signal line 81 on the other terminal 81b side, and the cooling capacity Wc of the first cold head 23.

[Math. 5]

$$R > \frac{n}{W_c} \frac{LA}{2} (T_2^2 - T_1^2) \qquad \cdots (6)$$

In a case where the resistance value R of the first signal line 81 falls in the range from the minimum value to the maximum value (in a case where Equations (4-2) and (6) are satisfied), the detection element 82 normally operates. That is, in a case where the resistance value R of the first signal line 81 falls within the range represented by the following Equation (7), the detection element 82 normally operates.

[Math. 6]

$$\frac{n}{W_c} \frac{LA}{2} (T_2^2 - T_1^2) < R < \frac{(R_n - R_s)R_{sh}I_b}{V_N} - R_{sh} - R_n \qquad \cdots (7)$$

For example, in Equation (7), when n = 2000, $T_2$ = 50 K, $R_n$ = 1000 Ω, $R_s$ = 0 Ω, $R_{sh}$ = 50 Ω, A = 10, and L = 2.44 × 10^{-8} WΩ/K² are substituted and $T_1$ = 3 K, Wc = 0.05 W, $I_b$ = 25 μA, and $V_N$ = 1.0 mV are further substituted, the range of the resistance value R of the first signal line 81 is a range larger than 12.2 Ω and smaller than 200 Ω.

Note that, the resistance value R of the first signal line 81 is adjusted by changing at least one of a length of the first signal line 81, a sectional area of the first signal line 81, and a material of the first signal line 81. The ratio A of the thermal resistance is adjusted by changing at least one of the length of the first signal line 81, the sectional area of the first signal line 81, and the material of the first signal line 81. In addition, the ratio A of the thermal resistance is adjusted by changing at least one of a length of the first ground line 41, a sectional area of the first ground line 41, and a material of the first ground line 41.

In addition, the heat flowing from the atmospheric stage 33 via the second signal line 83 is absorbed by the second cold head 25 in the sub-stage 32. Accordingly, even in a case where the resistance value of the second signal line 83 is set sufficiently smaller than the resistance values of the first signal line 81, the detection element 82, and the shunt resistor 87 and the amount of heat flowing in via the second signal line 83 increases, since the heat flowing in via the second signal line 83 is absorbed by the second cold head 25, the detection element 82 normally operates. Note that, the cooling capacity of the second cold head 25 is higher than the cooling capacity Wc of the first cold head 23.

Operational effects of the energy ray detection system 1 according to the embodiment described above will be described.

In the energy ray detection system 1 according to the present embodiment, when the energy ray is incident on the detection element 82 housed in the housing 20, the difference $\Delta V$ in the input voltage at which the energy ray is detected is input from the detection element 82 to the amplifier 85 of the signal processing circuit 84 outside the vacuum vessel 2 via the signal lines 81 and 83. In the energy ray detection system 1, the resistance value R of the first signal line 81 is larger than a value calculated based on the number n of first signal lines 81, the temperature $T_1$ of the first signal line 81 on the one terminal 81a side, the temperature $T_2$ of the first signal line 81 on the other terminal 81b side, and the cooling capacity Wc of the first cold head 23. According to such a configuration, for example, the resistance value R can be set such that the total amount of heat flowing into the n detection elements 82 is smaller than a value corresponding to the cooling capacity of the first cold head 23, and it is possible to prevent the low temperature state of each detection element 82 from being broken. In addition, in the energy ray detection system 1 according to the present embodiment, the resistance value R of the first signal line 81 is smaller than a value calculated based on the noise allowable voltage $V_N$ in the amplifier 85, the resistance value $R_{sh}$ of the shunt resistor 87, the resistance value $R_s$ in a case where the detection element 82 is OFF, the resistance value $R_n$ in a case where the detection element 82 is ON, and the bias current $I_b$ flowing through the detection element 82 in a case where the detection element 82 is OFF. According to such a configuration, for example, the resistance value R can be set such that the difference $\Delta V$ (the intensity of the signal from the detection element 82) in the input voltage between the case where the detection element 82 is ON and the case where the detection element is OFF is larger than the value corresponding to the noise allowable voltage $V_N$, and the signal from the detection element 82 can be normally detected. From the above, when the number of detection elements 82 is increased, it is possible to normally operate the detection element while improving the signal quality.

As described above, in the present embodiment, the range of the resistance value R of the first signal line 81 is determined from characteristics of the detection elements 82, cooling performance of the first cold head 23, and parameters of the signal processing circuit 84 such that the detection element 82 operates normally when the number of detection elements 82 is increased. As a result, the detection element 82 can be normally operated even in the energy ray detection system in which the number of detection elements 82 is larger than in the related art. For example, even in a case where the number of detection elements 82 that cannot be normally operated in a general-purpose cable is provided, the detection element 82 can be normally operated by adjusting the resistance value R of the first signal line 81 as described above. The energy ray detection system in which the number of detection elements 82 is larger than that in the related art may be, for example, an energy ray detection system in which the number of detection elements 82 is 30 or more, and more preferably an energy ray detection system in which the number of detection elements 82 is 100 or more.

Further, originally, it is necessary to define a condition necessary for the detector including the plurality of detection elements 82 to normally operate with respect to a plurality of objective variables such as the difference $\Delta V$ in the input voltage and the thermal resistance $R_T$. However, in the present embodiment, the condition can be defined by a single objective variable of the resistance value R of the first signal line 81. In other words, the detection elements including a large number of detection elements 82 can be operated by adjusting only the resistance value R of the first signal line without changing the characteristics of the detector itself including the plurality of detection elements 82.

In addition, in the energy ray detection system 1 according to the present embodiment, the first ground line 41 indirectly connects the detection element 82 and the ground potential connection portion 88. The resistance value R is present in a range represented by the following Equation (7):

[Math. 7]

$$\frac{n}{W_c}\frac{LA}{2}\left(T_2^2 - T_1^2\right) < R < \frac{R_{sh}\left(R_n - R_s\right)}{V_N}I_b - R_{sh} - R_n \qquad \cdots (7)$$

[where, in the above Equation (7), L is the Lorentz number, and A is a ratio of the combined thermal resistance of the first signal line 81 and the first ground line 41 to the thermal resistance of the first signal line 81]. According to such a configuration, the value of the resistance value R is set such that the amount of heat flowing into the n detection elements 82 does not exceed the cooling capacity $W_c$ of the first cold head 23 based on the Lorentz number L which is known constant and the ratio A. In addition, according to the above configuration, in a case where the intensity of the signal from the detection element 82 is estimated as the difference $\Delta V$ in the input voltage V between the case where the detection element 82 is ON and the case where the detection element is OFF, the value of the resistance value R is set such that the intensity of the signal from the detection element 82 exceeds the noise allowable voltage $V_N$. As a result, the resistance value R can be set such that the intensity of the signal from the detection element 82 exceeds the noise allowable voltage $V_N$ and the amount of heat flowing into the n detection elements 82 does not exceed the cooling capacity $W_c$ of the first cold head 23. Accordingly, when the number of detection elements 82 is increased, it is possible to normally operate the detection element while improving the signal quality.

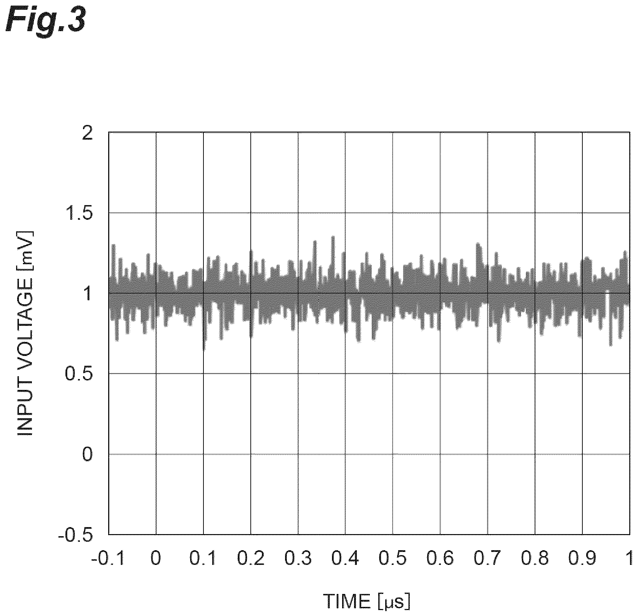

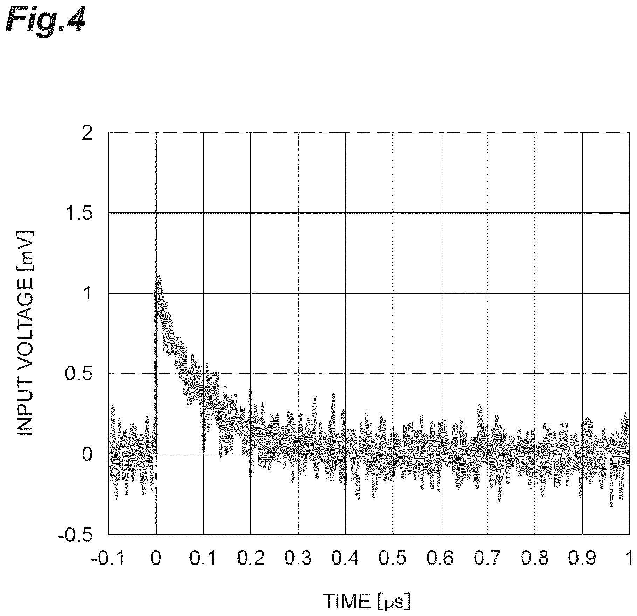

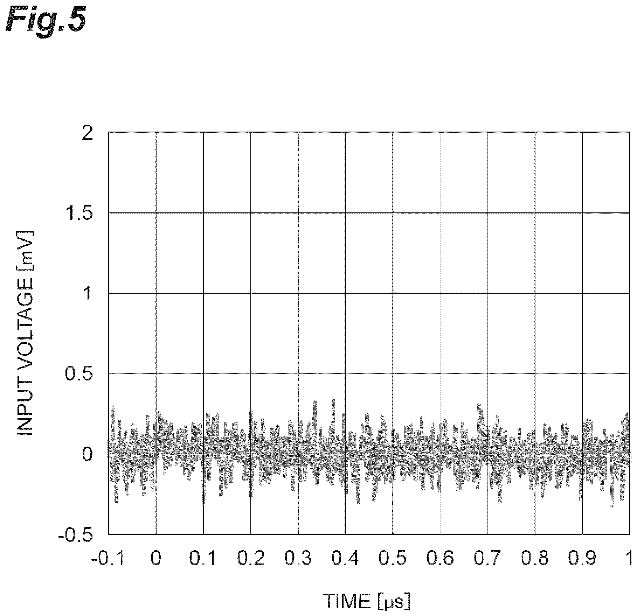

The operational effects will be described in detail with reference to FIGS. 3, 4, and 5. FIGS. 3, 4, and 5 are diagrams illustrating temporal changes in the input voltage V input to the amplifier 85 of the energy ray detection system 1. In FIGS. 3, 4, and 5, a vertical axis represents the input voltage V, and a horizontal axis represents time. FIG. 3 illustrates the temporal change in the input voltage V in a case where the resistance value R of the first signal line 81 is set to a range represented by the following Equation (8-1). FIG. 4 illustrates the temporal change in the input voltage V in a case where the resistance value R of the first signal line 81 is set to a range represented by the following Equation (7). FIG. 5 illustrates the temporal change in the input voltage V in a case where the resistance value R of the first signal line 81 is set to a range represented by the following Equation (8-2).

[Math. 8]

$$R < \frac{n}{W_c} \frac{LA}{2} (T_2^2 - T_1^2) \qquad \cdots (8-1)$$

$$\frac{n}{W_c} \frac{LA}{2} (T_2^2 - T_1^2) < R < \frac{R_{sh}(R_n - R_s)}{V_N} I_b - R_{sh} - R_n \qquad \cdots (7)$$

$$\frac{R_{sh}(R_n - R_s)}{V_N} I_b - R_{sh} - R_n < R \qquad \cdots (8-2)$$

In FIGS. 3, 4, and 5, the energy ray is incident on the detection element 82 at time 0 $\mu$s. In FIGS. 3 and 5, the difference $\Delta V$ in the input voltage cannot be confirmed. In the energy ray detection system corresponding to FIG. 3, since the amount of heat flowing into the detection element 82 from the first signal line 81 exceeds the cooling capacity $W_c$ of the first cold head 23, the low temperature state of the detection element 82 is broken and the detection element 82 does not normally operate. In addition, in the energy ray detection system corresponding to FIG. 5, the difference $\Delta V$ in the input voltage which is the signal from the detection element 82 is lower than the noise allowable voltage in the amplifier 85. On the other hand, in FIG. 4, since the resistance value R is set to an appropriate value, it can be seen that the difference $\Delta V$ in the input voltage can be observed. Accordingly, it is understood that, by the resistance value R of the first signal line 81 being in the range shown in Equation (7), when the number of detection elements 82 is increased, it is possible to normally operate the detection element while improving signal quality.

In addition, the operational effects will be described from another aspect. Specifically, assuming that the cooling capacity $W_c$ of the first cold head 23 and the bias current $I_b$ depend on the temperature $T_1$ of the main stage 31, the resistance value R at which the difference $\Delta V$ in the input voltage is maximized is calculated, and it is confirmed that the calculated value is included in the range represented by Equation (7). Note that, in the method for setting the resistance value R of the first signal line 81 described above, the cooling capacity $W_c$ of the first cold head 23 and the bias current $I_b$ are approximated as not depending on the temperature $T_1$ of the main stage 31, and each calculation is performed. In addition, in the following calculation, it is assumed that the detection element 82 is the element that detects the energy ray in the superconducting state and $R_s = 0$.

First, in a case where the amount of heat flowing into the main stage 31 and the cooling capacity $W_c$ of the first cold head 23 cancel out each other, a relational expression between the resistance value R of the first signal line 81 and the temperature $T_1$ of the main stage 31 is expressed as Equation (9). That is, the temperature $T_1$ of the main stage 31 can be derived from the resistance value R. Note that, the temperature $T_1$ dependency of the main stage 31 on the cooling capacity $W_c$ of the first cold head 23 capable of cooling to be 4 K or lower is generally expressed as $W_c = aTi - b$.

[Math. 9]

$$R = \frac{n}{aT_0 - b} \frac{LA}{2} (T_2^2 - T_1^2) \qquad \cdots (9)$$

Subsequently, the bias current $I_b$ is a numerical value obtained by multiplying a critical current $I_c$ of the detection element 82 by a constant C. $I_c$ has a $T_1$ dependency, and this dependency is known as the Ginkburg-Landau equation. Accordingly, the bias current $I_b$ is expressed as Equation (10). That is, the bias current $I_b$ can be derived from the temperature Ti of the main stage 31. Note that, the constant C may be 0 or more and 1 or less, and is, for example, 0.8. In addition, $T_c$ is a superconducting transition temperature. Here, $\Delta V$ is expressed as Equation (11) obtained by substituting $R_s = 0$ into Equation (3-3) by the resistance value R and the bias current $I_b$. From the above, the difference $\Delta V$ in the input voltage can be derived from the resistance value R.

[Math. 10]

$$I_b = CI_c = CI_{c0} \left( 1 - \left( \frac{T_1}{T_C} \right)^2 \right)^{\frac{3}{2}} \left( 1 + \left( \frac{T_1}{T_C} \right)^2 \right)^{\frac{1}{2}} \qquad \cdots (10)$$

$$\Delta V = V_{on} - V_{off} = \frac{R_{sh} R_n}{R_n + R + R_{sh}} I_b \qquad \cdots (11)$$

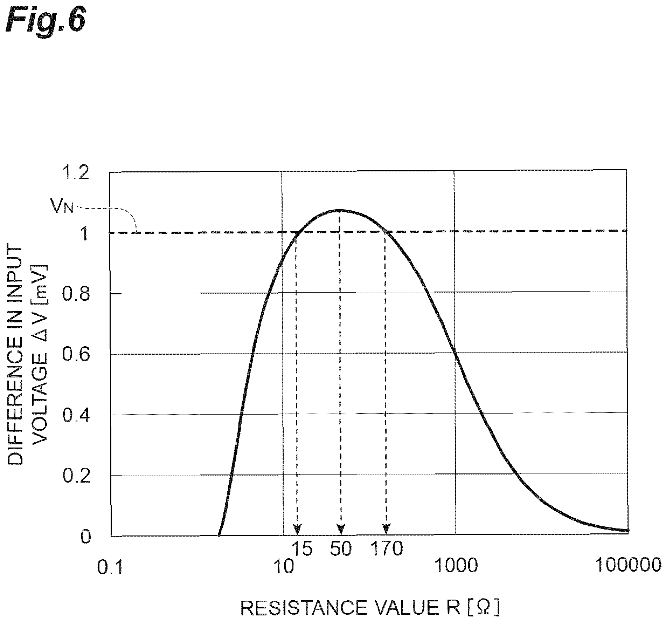

FIG. 6 is a diagram illustrating a relationship between the difference $\Delta V$ in the input voltage and the resistance value R of the first signal line 81. In FIG. 6, a vertical axis represents the difference $\Delta V$ in the input voltage, and a horizontal axis represents the resistance value R of the first signal line 81. FIG. 6 illustrates a relationship in a case where constants are substituted into Equations (9), (10), and (11) as follows. That is, n = 2000, $T_2$ = 50 K, $R_n$ = 1000 Ω, $R_{sh}$ = 50 Ω, A = 10, L = 2.44 × 10$^{-8}$ WΩ/K$^2$, a = 0.1 W/K, b = 0.25 W, C = 0.8, $T_c$ = 6 K, and $I_{c0}$ = 4.50 × 10$^{-5}$.

Here, when the difference $\Delta V$ in the input voltage is 1 mV or more, the difference $\Delta V$ can be detected as the signal from the detection element 82 (noise allowable voltage $V_N$ = 1.0 mV). At this time, the range of the resistance value R of the first signal line 81 is a range in which the difference $\Delta V$ in the input voltage is 1 mV or more, for example, a range larger than 15 Ω and smaller than 170 Ω. An optimum value of the resistance value R of the first signal line 81 in a case where the difference $\Delta V$ in the input voltage is maximized is 50 Ω.

Here, in Equation (7), when $W_c$ = 0.05 W and $I_b$ = 25 μA are set and the remaining constants are determined in the same manner as in FIG. 6, the range of the resistance value R of the first signal line 81 is a range larger than 12.2 Ω and smaller than 200 Ω. That is, in the present embodiment, the range based on Equation (7) derived by using approximation includes the optimum value of the resistance value R of the first signal line 81. Accordingly, the resistance value R of the first signal line 81 is in the range shown in Equation (7), and thus, it is possible to normally operate the detection element while improving the signal quality when the number of detection elements 82 is increased.

In addition, in the energy ray detection system 1 according to the present embodiment, the resistance value R of the first signal line 81 and the ratio A of the combined thermal resistance of the first signal line 81 and the first ground line 41 to the thermal resistance of the first signal line 81 are adjusted by the length of the first signal line 81 and the length of the first ground line 41. According to such a configuration, the resistance value R and the ratio A of the thermal resistance can be easily adjusted. As a result, it is possible to normally operate the detection element while improving signal quality by simple adjustment.

In addition, in the energy ray detection system 1 according to the present embodiment, the resistance value R of the first signal line 81 and the ratio A of the combined thermal resistance of the first signal line 81 and the first ground line 41 to the thermal resistance of the first signal line 81 are adjusted by the sectional area of the first signal line 81 and the sectional area of the first ground line 41. According to such a configuration, it is possible to easily adjust the resistance value R and the ratio A of the thermal resistance without changing the number of first signal lines 81. As a result, it is possible to normally operate the detection element while improving signal quality by simple adjustment.

In addition, in the energy ray detection system 1 according to the present embodiment, the resistance value R of the first signal line 81 and the ratio A of the combined thermal resistance of the first signal line 81 and the first ground line 41 to the thermal resistance of the first signal line 81 are adjusted by the material of the first signal line 81 and the material of the first ground line 41. According to such a configuration, the resistance value R and the ratio A of the thermal resistance can be easily adjusted. As a result, it is possible to normally operate the detection element while improving signal quality by simple adjustment.

In addition, in the energy ray detection system 1 according to the present embodiment, the detection element 82 is the element that detects the energy ray in the superconducting state, and the resistance value $R_s$ may be 0. According to such a configuration, since the intensity of the signal in a case where the detection element 82 detects the energy ray increases, an allowable value of the resistance value R also increases such that the intensity of the signal from the detection element 82 is larger than the value corresponding to the noise allowable voltage. As a result, a range in which the resistance value R can be obtained increases, and a degree of freedom in designing the energy ray detection system 1 can be improved.

Although the embodiment of the present disclosure has been described above, the present disclosure is not limited to the above embodiment, and may be modified or applied to other objects without changing the gist described in each claim.

In the energy ray detection system 1 according to the above embodiment, although one first signal line 81 and one first ground line 41 are included in each first connection portion 5, and the plurality of first connection portions 5 are provided, the present disclosure is not limited thereto. The plurality of first ground lines 41 are electrically connected to each other, and the plurality of first signal lines 81 and the plurality of first ground lines 41 may be integrated. More specifically, only one first connection portion 5 may be provided in the energy ray detection system 1, and the n first signal lines 81 and the plurality of first ground lines 41 may be integrated in the first connection portion 5. For example, the first connection portion 5 may be a cable or a substrate in which the n first signal lines 81 and the plurality of first ground lines 41 are integrated. In addition, for example, a planar transmission line such as a flexible cable such as an FPC cable may be formed by using the n first signal lines 81 and the plurality of first ground lines 41. According to such a configuration, it is possible to minimize a space for providing the first signal line 81 and the first ground line 41 inside the vacuum vessel 2, and as a result, downsizing of the detection system is realized.

In addition, in a case where only one first connection portion 5 is provided and the n first signal lines 81 and the plurality of first ground lines 41 are integrated in the first connection portion 5, $R_T$ is a value obtained by dividing the thermal resistance of the first connection portion 5 by the number n of first signal lines 81. In addition, the constant A is a ratio of a sum of the thermal resistance of one first signal line 81 and the thermal resistance obtained by dividing the thermal resistances of all the ground lines by the number n of first signal lines 81 to the thermal resistance of the first signal line 81.

In addition, in the energy ray detection system 1 according to the above embodiment, although one second signal line 83 and one second ground line 42 are included in each second connection portion 6 and the plurality of second connection portions 6 are provided, the present disclosure is not limited thereto. The plurality of second ground lines 42 may be electrically connected to each other, and the plurality of second signal lines 83 and the plurality of second ground lines 42 may be integrated. More specifically, only one second connection portion 6 may be provided in the energy ray detection system 1, and the n second signal lines 83 and the plurality of second ground lines 42 may be integrated in the second connection portion 6. For example, the second connection portion 6 may be a cable or a substrate in which the n second signal lines 83 and the plurality of second ground lines 42 are integrated. In addition, for example, a planar transmission line such as a flexible cable such as an FPC cable may be formed by using the n second signal lines 83 and the plurality of second ground lines 42. According to such a configuration, it is possible to minimize a space for providing the second signal line 83 and the second ground line 42 inside the vacuum vessel 2, and as a result, downsizing of the energy ray detection system 1 is realized.

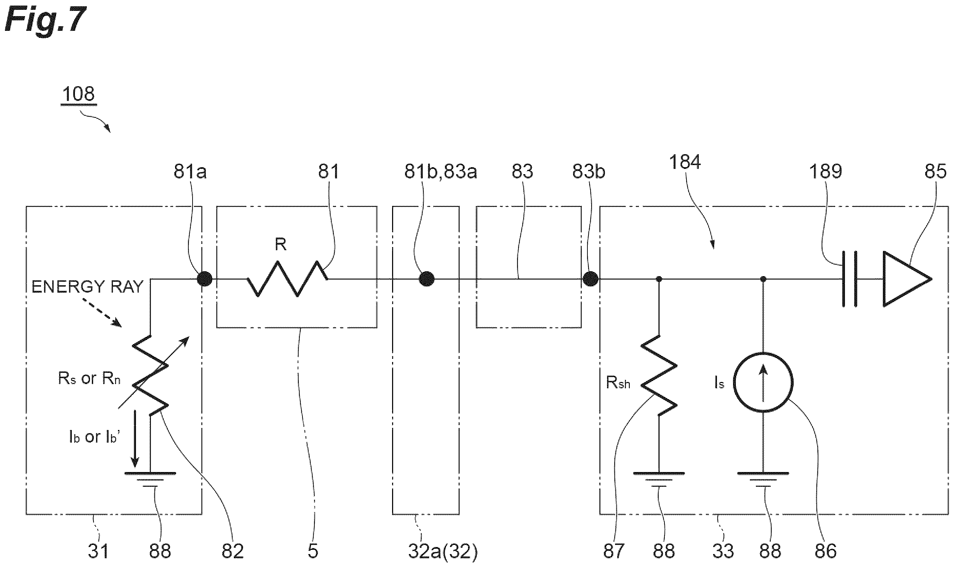

In addition, in the above embodiment, although the configuration of the signal processing circuit 84 includes the amplifier 85, the current source 86, and the shunt resistor 87, the present disclosure is not limited thereto. FIG. 7 is a diagram illustrating a circuit unit 108 according to the present modification. As illustrated in FIG. 7, a signal processing circuit 184 of the circuit unit 108 may have a capacitor 189 between a connection portion between the current source 86 and the other terminal 83b of the second signal line 83, and the amplifier 85. In this case, the input voltage is 0 V in a case where the detection element 82 is OFF, and the input voltage V generated in a case where the detection element 82 is ON can be detected as the difference $\Delta V$ in the input voltage.

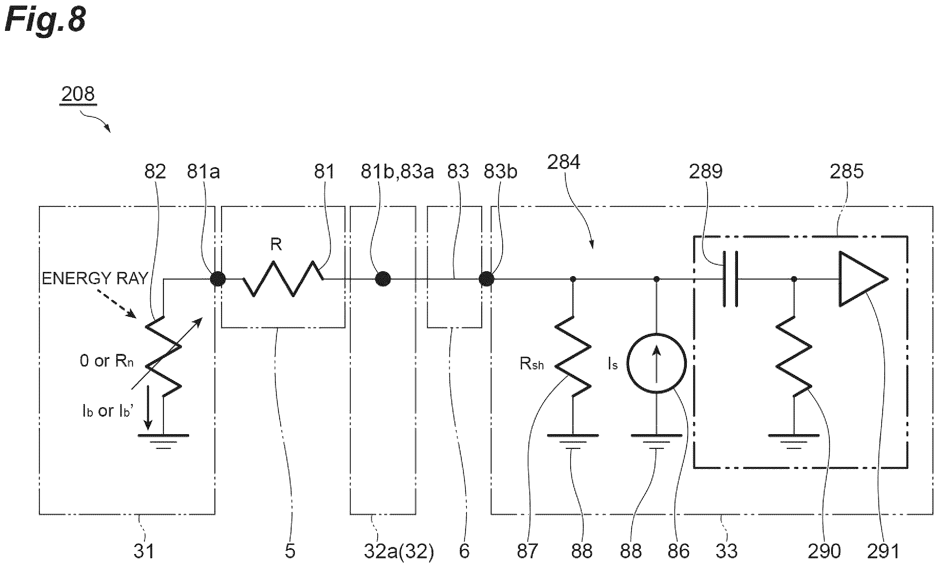

In addition, FIG. 8 is a diagram illustrating a circuit unit 208 according to the present modification. A signal processing circuit 284 of the circuit unit 208 may include an amplifier 285 instead of the amplifier 85. The amplifier 285 includes a capacitor 289, a resistor 290, and an amplifier 291. The capacitor 289 is connected to a connection portion between the current source 86 and the other terminal 83b of the second signal line 83. The amplifier 291 is connected to the capacitor 289. The resistor 290 is connected between a connection portion between the amplifier 291 and the capacitor 289 and the ground potential connection portion 88. In this case, the value of the resistance value R of the first signal line 81 is set to a range calculated by replacing the impedance $Z_{sh}$ obtained by combining the shunt resistor 87, the capacitor 289, and the resistor 290 with the resistance value $R_{sh}$ of the shunt resistor 87.

Further, in the above modification, the signal processing circuit 284 may not include the shunt resistor 87. In this case, the value of the resistance value R of the first signal line 81 is set to a range calculated by replacing the impedance $Z_{sh}$ obtained by combining the capacitor 289 and the resistor 290 with the resistance value $R_{sh}$ of the shunt resistor 87.

In addition, in the above embodiment, although the circuit unit 8 includes the first signal line 81, the detection element 82, the second signal line 83, and the signal processing circuit 84, the present disclosure is not limited thereto.

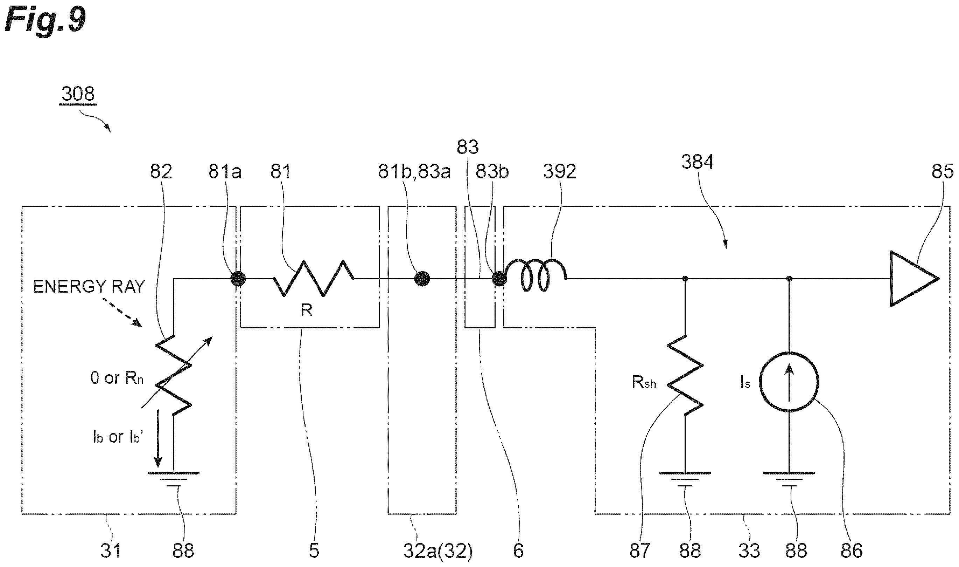

FIG. 9 is a diagram illustrating a circuit unit 308 according to the present modification. A signal processing circuit 384 of the circuit unit 308 may have a coil 392 directly connected to the other terminal 83b of the second signal line 83. In this case, since the coil 392 is provided at a position in series with the first signal line 81, the change in the bias current $I_b$ is delayed in a case where the detection element 82 is ON. Accordingly, since a heat generating portion in the detection element 82 expands and the resistance value $R_n$ in a case where the detection element 82 is ON increases, the difference $\Delta V$ in the input voltage can be increased. As a result, when the number of detection elements 82 is increased, it is possible to normally operate the detection element while improving the signal quality.

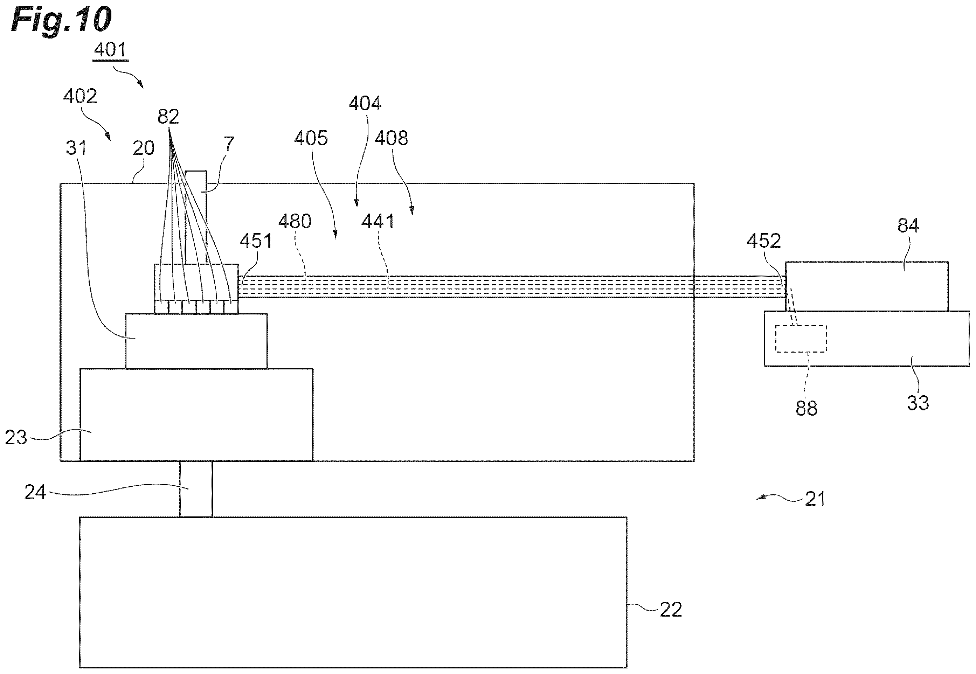

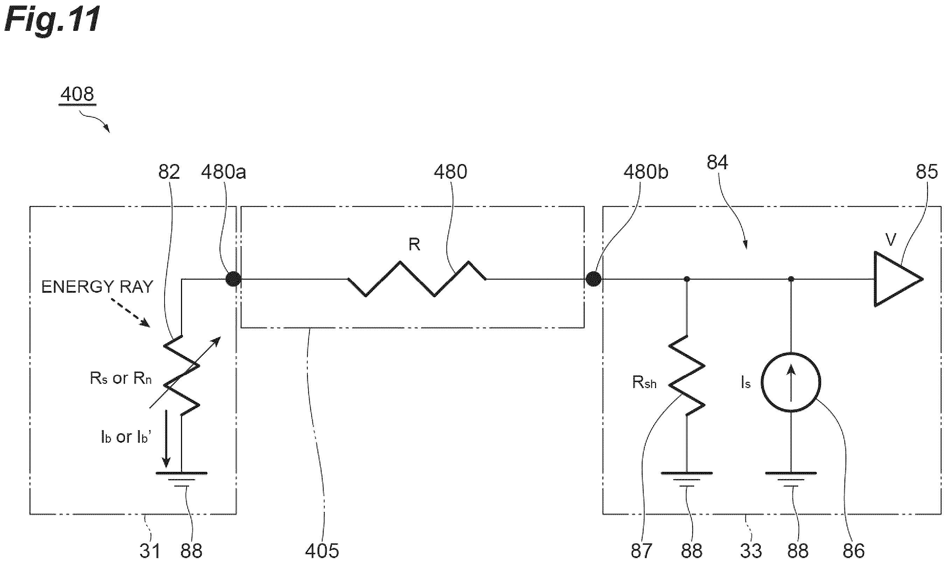

In addition, in the above embodiment, the energy ray detection system 1 may not include the second cold head 25, the hose 26, the sub-stage 32, and the second connection portion 6. FIG. 10 is a schematic configuration diagram illustrating an energy ray detection system 401 according to the present modification. FIG. 11 is a diagram illustrating an equivalent circuit of a circuit unit 408 according to the present modification. The energy ray detection system 401 according to the present modification includes a vacuum vessel 402, a main stage 31, an atmospheric stage 33, a ground connection portion 404, a plurality of first connection portions 405, and an optical fiber 7. Each circuit unit 408 is a circuit for detecting an energy ray formed by a signal line 480, the detection element 82, and corresponding elements in the signal processing circuit 84. In the energy ray detection system 401, n (n is an integer of 2 or more) circuit units 408 are provided.

As illustrated in FIG. 10, the energy ray detection system 401 does not include the sub-stage 32 and the second connection portion 6. Unlike the vacuum vessel 2, the vacuum vessel 402 does not include the second cold head 25 and the hose 26. The ground connection portion 404 includes a plurality of ground lines 441. The plurality of ground lines 441 are electrically connected to each other. Each ground line 441 connects the detection element 82 and the ground potential connection portion 88. Note that, in the present modification, the ground connection portion 404 includes the ground line 441 for each circuit unit 408.

One end portion 451 of the first connection portion 405 is fixed to the main stage 31. The other end portion 452 of the first connection portion 405 is fixed to the atmospheric stage 33. In the present modification, the first connection portion 405 is provided for each circuit unit 408 (details will be described later.). The first connection portion 405 includes one signal line 480 and one ground line 441 therein. In the first connection portion 405, each ground line 441 is integrated with the signal line 480 while being electrically insulated from the signal line 480. For example, the first connection portion 405 is a coaxial cable including one signal line 480 that is an internal conductor surrounded by the ground line 441 that is an external conductor. Note that, in the present modification, only one first connection portion 405 may be provided. In this case, the n signal lines 480 and the plurality of ground lines 441 may be integrated in the first connection portion 405.

As illustrated in FIG. 11, in the circuit unit 408, the signal line 480 is provided instead of the first signal line 81 and the second signal line 83. A part of the signal line 480 is housed in the housing 20. The detection element 82 is connected between one terminal 480a of the signal line 480 and the ground potential connection portion 88. The signal processing circuit 84 is directly connected to the other terminal 480b of the signal line 480.

Instead of the resistance value of the first signal line 81, a resistance value of the signal line 480 is set as the resistance value R. In this case, a minimum value of the resistance value R of the signal line 480 is set to a value calculated based on the thermal resistance $R_T$ of the first connection portion 405, the cooling capacity $W_c$ of the first cold head 23, the temperature $T_1$ of the one terminal 480a side of the signal line 480, the temperature $T_2$ of the other terminal 480b side of the signal line 480, and the temperature T of the first connection portion 405. Note that, $T_1$ is the temperature of the main stage 31, and $T_2$ is the temperature of the atmospheric stage 33.

In addition, in the above embodiment, a plurality of stages may be provided between the main stage 31 and the atmospheric stage 33. In this case, a stage closest to the main stage 31 among the stages on which the coolers such as the second cold head 25 are provided is the sub-stage 32 for determining a setting range of the resistance value R.

In addition, in the above embodiment, although the resistance value R of the first signal line 81 is set, the cooling capacity $W_c$ of the first cold head 23 may be set to define a range of the cooling capacity $W_c$ in which the detection element 82 normally operates. As a result, a detector having the number of detection elements 82 that cannot be normally operated in the general-purpose cable and a general-purpose refrigerator can be normally operated by increasing the cooling capacity of the first cold head 23.

In addition, in the above embodiment, although the energy ray detected by the detection element 82 is the photon, the present disclosure is not limited thereto. For example, the detected energy ray may be a charged particle. For example, the charged particle to be detected may be an electron, and the detector having the plurality of detection elements 82 may be a superconducting single electron detector (SSED). In addition, for example, the charged particle to be detected may be an ion, and the detector may be a superconducting strip ion detector (SSID). In addition, for example, the charged particle to be detected may be a proton, and the detector may be a proton detector which is a kind of SSID. Further, the detected energy ray may be a neutron and the detector may be a neutron detector. According to such a configuration, at least one of the energy rays of the photon, the electron, the proton, the neutron, and the ion can be detected with higher accuracy. In addition, as described above, in a case where the energy ray detected by the detection element 82 is an X-ray, a charged particle, a neutron, and the like, a window material made of an energy ray transmitting material may be provided in the housing 20 or the like instead of the optical fiber 7.

In addition, in the above embodiment, although the predetermined potential connected to the ground potential connection portion 88 is the ground potential, the present disclosure is not limited thereto. For example, the predetermined potential connected to the ground potential connection portion 88 may be a potential other than the ground potential. In this case, the circuit unit 8, 108, 208, 308, or 408 may be a differential transmission line, and a signal may be read out by each circuit unit 8, 108, 208, 308, or 408.

In addition, in the above embodiment, the predetermined potential is the ground potential, the energy ray detection system further includes a ground line that connects the detection element and the predetermined potential, and the resistance value R is present within a range represented by the following Equation (1):

[Math. 11]

$$\frac{n}{W_c}\frac{LA}{2}(T_2^2 - T_1^2) < R < \frac{Z_{sh}(R_n - R_s)}{V_N}I_b - Z_{sh} - R_n \qquad \cdots(1)$$

[where, in the above Equation (1), L is a Lorentz number, and A is a ratio of a combined thermal resistance of the signal line and the ground line to a thermal resistance of the signal line]. According to such a configuration, the value of the resistance value R is set based on the Lorentz number L which is a known constant and the ratio A such that the amount of heat flowing into the n detection elements does not exceed the cooling capacity of the cooler. In addition, according to the above aspect, in a case where the intensity of the signal from the detection element is estimated as the potential difference between the voltage input to the amplifier in a case where the energy ray of the detection element is detected and the voltage input to the amplifier in a case where the energy ray of the detection element is not detected, the value of the resistance value R is set such that the intensity of the signal from the detection element exceeds the noise allowable voltage. As a result, the resistance value R can be set such that the intensity of the signal from the detection element exceeds the noise allowable voltage and the amount of heat flowing into the n detection elements does not exceed the cooling capacity of the cooler. Accordingly, when the number of detection elements is increased, it is possible to normally operate the detection element while improving the signal quality.

In addition, in the above embodiment, the resistance value R of the signal line and the ratio A of the combined thermal resistance of the signal line and the ground line to the thermal resistance of the signal line are suitably adjusted by the length of the signal line and the length of the ground line. According to such a configuration, the resistance value R and the ratio A of the thermal resistance can be easily adjusted. As a result, it is possible to normally operate the detection element while improving signal quality by simple adjustment.

In addition, in the above embodiment, the resistance value R of the signal line and the ratio A of the combined thermal resistance of the signal line and the ground line to the thermal resistance are suitably adjusted by the sectional area of the signal line and the sectional area of the ground line. According to such a configuration, the resistance value R and the ratio A of the thermal resistance can be easily adjusted. As a result, it is possible to normally operate the detection element while improving signal quality by simple adjustment.

In addition, in the above embodiment, the resistance value R of the signal line and the ratio A of the combined thermal resistance of the signal line and the ground line to the thermal resistance of the signal line are suitably adjusted by the material of the signal line and the material of the ground line. According to such a configuration, the resistance value R and the ratio A of the thermal resistance can be easily adjusted. As a result, it is possible to normally operate the detection element while improving the signal quality by simple adjustment.

In addition, in the above embodiment, suitably, the plurality of ground lines are electrically connected to each other, and the plurality of signal lines and the plurality of ground lines are integrated. According to such a configuration, it is possible to minimize the space for providing the signal line and the ground line inside the vacuum vessel, and as a result, downsizing of the detection system is realized.

In addition, in the above embodiment, the energy ray detected by the detection element is suitably at least one of the photon, the charged particle, and the neutron. According to such a configuration, at least one of the energy rays by the photon, the charged particle, and the neutron can be detected with higher accuracy.

In addition, in the above embodiment, the detection element is suitably the element that detects the energy ray in the superconducting state, and the resistance value $R_s$ is 0. According to such a configuration, since the signal intensity in a case where the detection element detects the energy ray increases, the allowable value of the resistance value R such that the intensity of the signal from the detection element is larger than the value corresponding to the noise allowable voltage also increases. As a result, the range in which the resistance value R can be obtained increases, and the degree of freedom in designing the energy ray detection system can be improved.

Reference Signs List

1, 401 energy ray detection system
2, 402 vacuum vessel
23 first cold head (cooler)
41 first ground line (ground line)
8, 108, 208, 308, 408 circuit unit
81 first signal line (signal line)
81a one terminal
81b other terminal
82 detection element
84, 184, 284, 384 signal processing circuit
85, 285 amplifier
86 current source
87 shunt resistor (circuit element)
441 ground line
480 signal line
480a one terminal
480b other terminal

## Claims

1. An energy ray detection system comprising:

   a vacuum vessel having a cooler; and
   n (n is an integer of 2 or more) circuit units that each have a signal line of which at least a part is housed in the vacuum vessel, a detection element which is housed in the vacuum vessel, is connected between one terminal of the signal line and a predetermined potential, and is configured to detect an energy ray in a low temperature state, and a signal processing circuit which is directly or indirectly connected to an other terminal of the signal line, and is disposed outside the vacuum vessel, wherein
   the signal processing circuit includes an amplifier connected to the other terminal and a current source and a circuit element connected in parallel with each other between the other terminal and the predetermined potential, and
   a resistance value R of the signal line is larger than a value calculated based on the number n of signal lines, a temperature $T_1$ of the signal line on the one terminal side, a temperature $T_2$ of the signal line on the other terminal side, and a cooling capacity Wc of the cooler, and is smaller than a value calculated based on a noise allowable voltage $V_N$ in the amplifier, an impedance $Z_{sh}$ of the circuit element, a resistance value $R_s$ of the detection element in a case where the detection element does not detect the energy ray, a resistance value $R_n$ of the detection element in a case where the detection element detects the energy ray, and a current $I_b$ flowing through the detection element in a case where the detection element does not detect the energy ray.

2. The energy ray detection system according to claim 1, wherein

   the predetermined potential is a ground potential,
   the energy ray detection system further includes a ground line that connects the detection element and the predetermined potential, and
   the resistance value R is present within a range represented by the following Equation (1):
   [Math. 1]

$$\frac{n}{W_c}\frac{LA}{2}\left(T_2^2 - T_1^2\right) < R < \frac{Z_{sh}(R_n - R_s)}{V_N}I_b - Z_{sh} - R_n \qquad \cdots (1)$$

   [where, in the above Equation (1), L is a Lorentz number, and A is a ratio of a combined thermal resistance of the signal line and the ground line to a thermal resistance of the signal line].

3. The energy ray detection system according to claim 2, wherein
   the resistance value R of the signal line and the ratio A of the combined thermal resistance of the signal line and the ground line to the thermal resistance of the signal line are adjusted by a length of the signal line and a length of the ground line.

4. The energy ray detection system according to claim 2 or 3, wherein
the resistance value R of the signal line and the ratio A of the combined thermal resistance of the signal line and the ground line to the thermal resistance of the signal line are adjusted by a sectional area of the signal line and a sectional area of the ground line.

5. The energy ray detection system according to any one of claims 2 to 4, wherein
the resistance value R of the signal line and the ratio A of the combined thermal resistance of the signal line and the ground line to the thermal resistance of the signal line are adjusted by a material of the signal line and a material of the ground line.

6. The energy ray detection system according to any one of claims 2 to 5, wherein

    a plurality of the ground lines are electrically connected to each other, and
    a plurality of the signal lines and the plurality of ground lines are integrated.

7. The energy ray detection system according to any one of claims 1 to 6, wherein
the energy ray detected by the detection element is at least one of a photon, a charged particle, and a neutron.

8. The energy ray detection system according to any one of claims 1 to 7, wherein

    the detection element is an element configured to detect the energy ray in a superconducting state, and
    the resistance value $R_s$ is 0.

**Fig.1**

EP 4 462 091 A1

*Fig.2*

8

ENERGY RAY

$R_s$ or $R_n$

$I_b$ or $I_b'$

R

$R_{sh}$

$I_s$

V

82  81a  81  81b,83a  83  83b  84  85

31  88  5  32a(32)  6  87  88  33  88  86

EP 4 462 091 A1

17

Fig.3

Fig.4

*Fig.5*

## Fig.6

**Fig.7**

# Fig.8

Fig.9

EP 4 462 091 A1

*Fig.10*
401

**Fig.11**

## INTERNATIONAL SEARCH REPORT

| International application No. |
| --- |
| **PCT/JP2022/044611** |

**A. CLASSIFICATION OF SUBJECT MATTER**

**G01J 1/02**(2006.01)i; **G01J 1/44**(2006.01)i; **G01J 11/00**(2006.01)i; **G01T 1/16**(2006.01)i; **G01T 1/26**(2006.01)i; **H10N 60/00**(2023.01)i
FI: G01J1/02 R; G01J1/44 A; G01J11/00; H10N60/00 A; G01T1/16 B; G01T1/26

According to International Patent Classification (IPC) or to both national classification and IPC

**B. FIELDS SEARCHED**

Minimum documentation searched (classification system followed by classification symbols)

G01J 1/00-1/02; G01J 1/42-1/46; G01J 11/00; G01T 1/16; G01T 1/26; H01L 27/14-27/148; H01L 31/08-31/09; H04B 10/00-10/90;H04N 5/30-5/33; H04N 23/11; H04N 23/20-23/30; H04N 25/00; H04N 25/20-25/61; H04N 25/615-25/79; H10N 60/00-60/12; H10N 60/35; H10N 60/82-60/85; H10N 69/00

Documentation searched other than minimum documentation to the extent that such documents are included in the fields searched

Published examined utility model applications of Japan 1922-1996
Published unexamined utility model applications of Japan 1971-2023
Registered utility model specifications of Japan 1996-2023
Published registered utility model applications of Japan 1994-2023

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
| --- | --- | --- |
| Y | JP 2000-277819 A (KYOCERA CORP.) 06 October 2000 (2000-10-06)<br>paragraphs [0001]-[0006], [0018], [0035]-[0038], [0044]-[0048], [0065], fig. 1, 2 | 1-8 |
| Y | JP 2008-244445 A (CANON KABUSHIKI KAISHA) 09 October 2008 (2008-10-09)<br>paragraphs [0013], [0031], fig. 1, 7 | 1-8 |
| Y | JP 2018-074026 A (NATIONAL INSTITUTE OF INFORMATION & COMMUNICATIONS TECHNOLOGY) 10 May 2018 (2018-05-10)<br>paragraphs [0048], [0049], fig. 3 | 2-6 |
| A | JP 2020-016543 A (KIOXIA CORP.) 30 January 2020 (2020-01-30)<br>entire text, fig. 1-13 | 1-8 |
| A | JP 2014-196983 A (NATIONAL INSTITUTE OF ADVANCED INDUSTRIAL SCIENCE AND TECHNOLOGY) 16 October 2014 (2014-10-16)<br>entire text, fig. 1-7 | 1-8 |

✓ Further documents are listed in the continuation of Box C.    ✓ See patent family annex.

| | |
| --- | --- |
| * Special categories of cited documents:<br>"A" document defining the general state of the art which is not considered to be of particular relevance<br>"E" earlier application or patent but published on or after the international filing date<br>"L" document which may throw doubts on priority claim(s) or which is cited to establish the publication date of another citation or other special reason (as specified)<br>"O" document referring to an oral disclosure, use, exhibition or other means<br>"P" document published prior to the international filing date but later than the priority date claimed | "T" later document published after the international filing date or priority date and not in conflict with the application but cited to understand the principle or theory underlying the invention<br>"X" document of particular relevance; the claimed invention cannot be considered novel or cannot be considered to involve an inventive step when the document is taken alone<br>"Y" document of particular relevance; the claimed invention cannot be considered to involve an inventive step when the document is combined with one or more other such documents, such combination being obvious to a person skilled in the art<br>"&" document member of the same patent family |

| Date of the actual completion of the international search | Date of mailing of the international search report |
| --- | --- |
| **29 January 2023** | **14 February 2023** |

| Name and mailing address of the ISA/JP | Authorized officer |
| --- | --- |
| **Japan Patent Office (ISA/JP)**<br>**3-4-3 Kasumigaseki, Chiyoda-ku, Tokyo 100-8915**<br>**Japan** | |
| | Telephone No. |

Form PCT/ISA/210 (second sheet) (January 2015)

<table>
<tr><td colspan="3">INTERNATIONAL SEARCH REPORT</td><td>International application No.<br><br>**PCT/JP2022/044611**</td></tr>
</table>

**C. DOCUMENTS CONSIDERED TO BE RELEVANT**

| Category* | Citation of document, with indication, where appropriate, of the relevant passages | Relevant to claim No. |
|---|---|---|
| A | JP 2009-021478 A (NATIONAL INSTITUTE OF ADVANCED INDUSTRIAL SCIENCE AND TECHNOLOGY) 29 January 2009 (2009-01-29)<br>entire text, fig. 1-3 | 1-8 |
| A | JP 2006-126001 A (NATIONAL INSTITUTE OF ADVANCED INDUSTRIAL SCIENCE AND TECHNOLOGY) 18 May 2006 (2006-05-18)<br>entire text, fig. 1-5 | 1-8 |

Form PCT/ISA/210 (second sheet) (January 2015)

Form PCT/ISA/210 (patent family annex) (January 2015)

**INTERNATIONAL SEARCH REPORT**
Information on patent family members

International application No.

**PCT/JP2022/044611**

| Patent document cited in search report | | | Publication date (day/month/year) | Patent family member(s) | Publication date (day/month/year) |
|---|---|---|---|---|---|
| JP | 2000-277819 | A | 06 October 2000 | (Family: none) | |
| JP | 2008-244445 | A | 09 October 2008 | US  2008/0203311  A1 paragraphs [0039], [0057], fig. 1, 7 | |
| JP | 2018-074026 | A | 10 May 2018 | (Family: none) | |
| JP | 2020-016543 | A | 30 January 2020 | US  2020/0033488  A1 | |
| JP | 2014-196983 | A | 16 October 2014 | (Family: none) | |
| JP | 2009-021478 | A | 29 January 2009 | (Family: none) | |
| JP | 2006-126001 | A | 18 May 2006 | (Family: none) | |

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- **A. J. KERMAN** ; **E. A. DAULER** ; **W. E. KEICHER** ; **J. K.W. YANG** ; **K. K.BERGGREN** ; **G. GOLTSMAN** ; **B. VORONOV**. Kinetic-inductance-limited reset time of superconducting nanowire photon counters. *Appl. Phys. Lett.*, 2006, vol. 88, 111116